(19)

Europäisches
Patentamt
European
Patent Office
Office européen
des brevets

(11) **EP 1 837 994 B1**

(12) **EUROPEAN PATENT SPECIFICATION**

(45) Date of publication and mention
of the grant of the patent:
**02.12.2009 Bulletin 2009/49**

(51) Int Cl.:
***H03L 7/085*** (2006.01)        ***H03D 13/00*** (2006.01)
***G01S 1/00*** (2006.01)

(21) Application number: **06111566.3**

(22) Date of filing: **22.03.2006**

(54) **Wideband frequency discriminator and radiolocalization receiver**

Breitband Frequenzdiskriminator und Funkortungsempfänger

Dispositif discriminateur de fréquence à large bande et récepteur de radiolocalisation

(84) Designated Contracting States:
**AT BE BG CH CY CZ DE DK EE ES FI FR GB GR
HU IE IS IT LI LT LU LV MC NL PL PT RO SE SI
SK TR**

(43) Date of publication of application:
**26.09.2007 Bulletin 2007/39**

(73) Proprietor: **Qualcomm Incorporated
San Diego, CA 92121 (US)**

(72) Inventor: **Brenner, Joel
6864 Arzo (CH)**

(74) Representative: **P&TS
Patents & Technology Surveys SA
Rue des Terreaux 7
Postfach 2848
2001 Neuchâtel (CH)**

(56) References cited:
**EP-A- 0 788 225        WO-A-02/25829
US-A- 5 291 081**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Field of the invention

The current invention relatesto a method of estimating the frequency of a signal, and to a corresponding device. In particular, but not exclusively, the present invention relatesto the application of the aforementioned method and device to the acquisition and tracking of localization signal like, for example, the signal emitted from one or more GPS(Global Positioning System) satellites, or the signal involved in another radio localization system.

Description of related art

The frequency estimate, in particular the frequency estimate of sinusoidal signals, isan operation used in a large number of applications.

Functionally speaking, the term frequency discriminator is employed here to indicate an algorithm or a mathematical operation that, applied to a vector representing a sampled signal, is able to estimate the fundamental frequency of the signal itself. Similarly, the term frequency discriminator may also indicate, in the contest of thisinvention, a portion of software for determining the frequency of a signal represented for example by a seriesof time samples. The term frequency discriminator also designatesin the following, when referred to a device, an element of electronic circuitry arranged or programmed in a manner as to estimate the fundamental frequency of an analogue or digital signal present to itsinput.

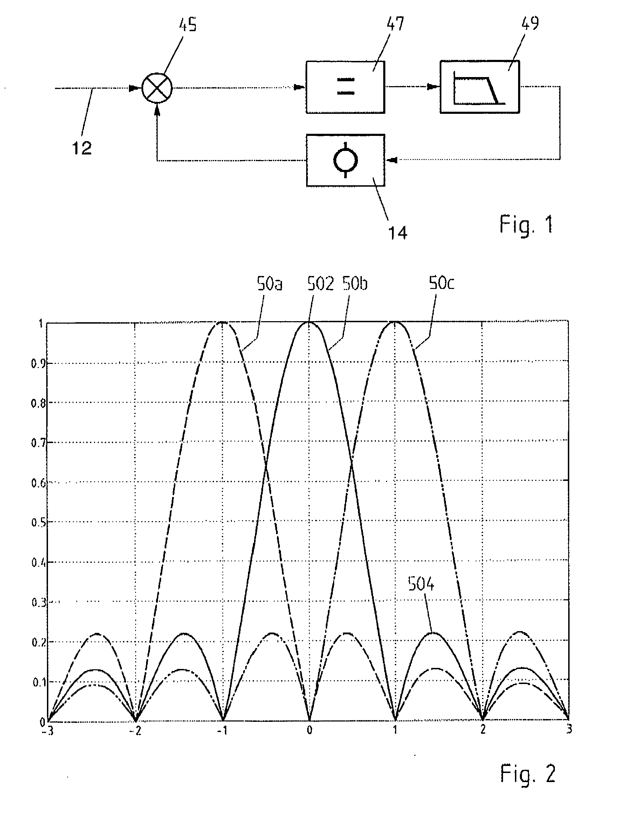

An example of utilization of a frequency discriminator isthe FLL (Frequency Locked Loop) represented schematically in figure 1. In this example an incoming signal 42 is combined with the signal of a local oscillator 44 in a mixer 45. The resulting difference frequency is applied to a frequency discriminator 47. The result of the frequency discriminator isin principle proportional to the difference between the fundamental input's frequency and a nominal frequency, and isused to drive the local oscillator in a feedback loop comprising the filter 49 so that it istuned at the same frequency asthe received signal.

An important application of frequency discriminator isin the Carrier tracking loop of GPSreceivers. The operation of GPS receivers usually comprises an acquisition mode, in which the signal received from the Space Vehicles (SV) are searched, and a tracking mode, in which the acquired signals are followed both in carrier frequency or phase and in code phase.

The frequency of the signal received from SV in a GPS system is in principle affected by a number of instrumental errors, for example frequency bias and drift of the local oscillators, aswell as by a physical Doppler shift, related to the relative speed between the SV and the receiver, which must be appropriately measured, in order to maintain tracking of the SV and arrive at a position determination. This is commonly realized, in GPS receivers, by means of PLL and FLLfeedback loops.

Typically, the FLL loop is used during the acquisition phase, in reason of itssuperior noise immunity. The PLL provides better tracking performances when the signal strength isadequate. A FLL fallback mode is often provided, asa substitute of the PLL, for tracking weak signals, and during dynamic peaksdue to the motion of the receiver.

In a large number of applications the frequency estimation is done by applying the frequency mathematical definition of the frequency asthe time-derivative of the phase, $f=\dot{\varphi}$. The incremental ratio of the phase isthen taken asan estimator of the frequency.

$$f(x,t_n) = \frac{\varphi(x,t_n) - \varphi(x,t_{n-1})}{\Delta t_{n;n-1}} \qquad\qquad 1)$$

Thisapproach, however, is not practically available when noise exceedsa certain threshold, in which case the phase signal isnot clearly detectable.

Another common approach is to use time-domain frequency discrimination, like it will be described in the following. Such discriminators, unfortunately, exhibit a rather narrow locking frequency range and spurious zero or discontinuity points outside the locking range. When such discriminators are employed in a frequency control loop, the external zero or discontinuity points generate spurious stable locking position outside of the design locking range. The time domain-based phase derivative discriminator described above is also affected by the same problem.

Another possible method implies the extraction of one or more DFT (Discrete Fourier Transform) of the input signal. Such partial amplitudes can be mathematically combined in various ways to provide the desired frequency.

US5290181 describes a radio receiver with such a frequency discriminator, comprising a DFT calculator which allows to detect the maximum level spectral components whose peak levels are extracted to estimate the frequency on the input signal.

Known DFT frequency discriminators are however affected by nonlinearities and out of range zero or discontinuity points, and therefore share the limitation of the previous devices.

It is a goal of the present invention to provide a frequency discriminator which is free from the above shortcomings, and in particular to provide a frequency discriminator having an extended locking range, and which is stable within its locking range.

A further goal of the present invention is to provide a frequency discriminator without spurious locking point outside the locking range.

It is a further goal of the invention to provide a frequency control circuit having an improved precision, as well as a radiolocalization receiver employing it.

Brief summary of the invention

According to the invention, these aims are achieved by means of the object of the independent claims. Further optional features are the object of the dependent claims.

Brief Description of the Drawings

The invention will be better understood with the aid of the description of an embodiment given by way of example and illustrated by the figures, in which:

Figure 1 diagrammatically showsa known FLL including a frequency discriminator.

Figure 2 representsthe absolute value of the transfer function of three DFToperationscentred on three adjacent frequency bins.

Figure 3 showsthe response of a frequency discriminator based on two of the DFTof figure 2, in ideal noiseless conditions.

Figure 4 showsthe gain of the discriminator of figure 3.

Figure 5 showsthe behaviour of the discriminator of figure 3 in presence of normal distributed noise.

Figure 6 showsthe response of a frequency discriminator based on the three DFTof figure 2, in ideal noiseless conditions.

Figure 7 showsthe behaviour of the frequency discriminator of figure 6, in presence of normal distributed noise.

Figure 8 showsthe absolute value of three DFT operationsshifted of half frequency bin.

Figure 9 showsthe response of a frequency discriminator based on the two extreme DFT of figure 8.

Figure 10 showsthe gain of the discriminator of figure 9.

Figure 11 showsthe behaviour of the frequency discriminator of figure 9, in presence of normal distributed noise.

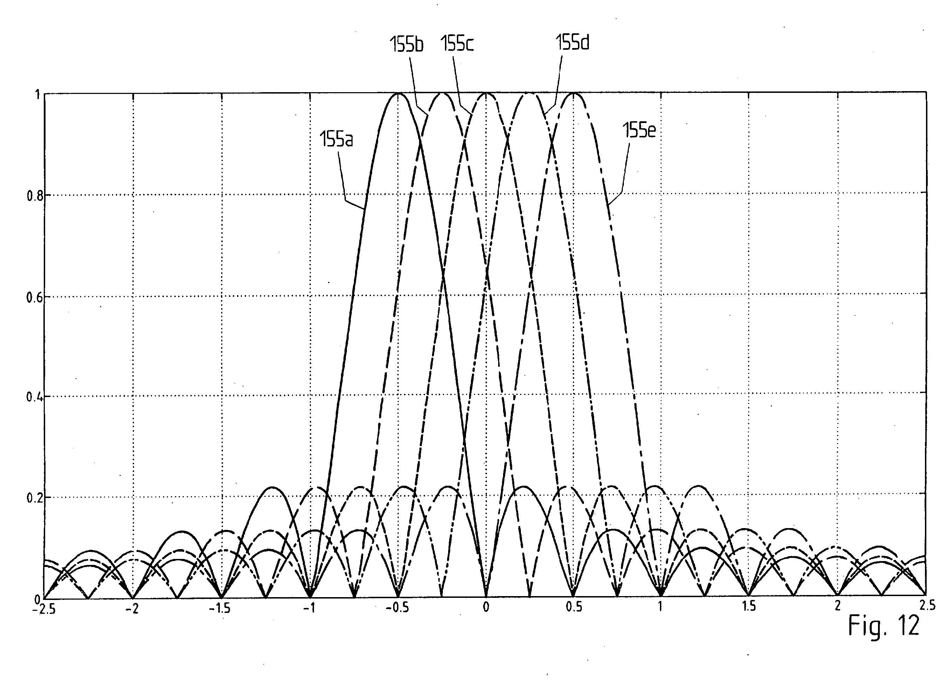

Figure 12 representsthe absolute value of five DFT operations shifted of half frequency bins.

Figure 13 showsthe response of a frequency discriminator based on the DFT of figure 12.

Figure 14 representsthe gain of a frequency discriminator based on the DFT of figure 12.

Figure 15 representsthe transfer function of two shifted compound operator used in the discriminator of figure 14.

Figure 16 isa diagrammatic comparison of the response of some frequency discriminatorsof the present invention and of some frequency discriminator belonging to the state of the art.

Figure 17 schematically showsa receiving and tracking module of a GPSreceiver according to an aspect of the present invention.

Figure 18 schematically represents a frequency discriminator module comprised in the receiver of figure 16.

Detailed Description of possible embodiments of the Invention

A well-known frequency discriminator, widely used, for example in radiolocalization receivers, is the simple "cross" discriminator, which is expressed by the formula:

$$Cross = I_1 \cdot Q_2 - I_2 \cdot Q_1 \qquad\qquad 2)$$

where $I_1$, $I_2$ are the real components of a complex sinusoidal signal at two times $T_1 < T_2$, and $Q_1$ and $Q_2$ are the corresponding imaginary component of the same signal at the same times $T_1$ and $T_2$. The observation time $\Delta T = T_2 - T_1$ is related to the nominal locking range $W_{Cross} = \dfrac{1}{2 \cdot \Delta T}$.

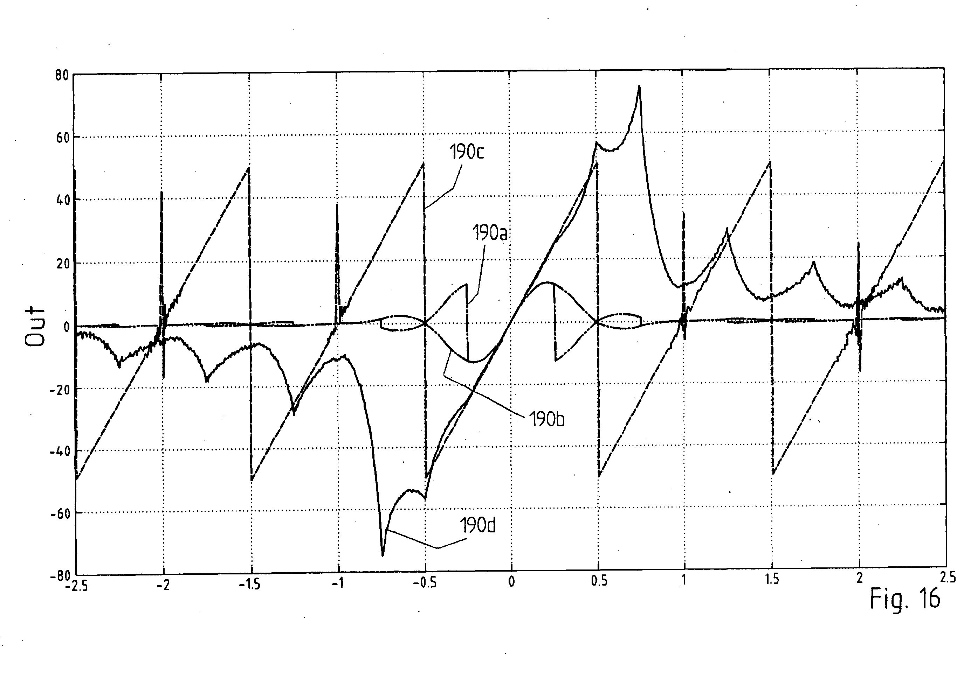

With reference to figure 16, together with the output 190d of a discriminator according to the invention, the response of the "cross" discriminator is represented by the curve 190b. It can be appreciated that, while it is well-behaved within its locking range, the output of the "cross" discriminator present stable locking zeros outside it.

Figure 16 also presents other known variants of this class of discriminator, the "signDotCross" discriminator, corresponding to curve 190a

$$Dot = I_1 \cdot I_2 + Q_1 \cdot Q_2$$
$$SignDotCross = Sign(Dot) \cdot Cross \qquad\qquad 3)$$

and the arctangent discriminator, whose output is exemplified by curve 190c

$$AtanDisc = \arctan 2(Cross, Dot) \qquad\qquad 4)$$

Both these discriminators exhibit zero or discontinuity points, which correspond to false locking points outside the operating range.

It is known to use Discrete Fourier Transform (DFT) to realize a frequency discriminator on digital signals. Conceptually, this class of discriminators is based on the principle of comparing the output of at least two distinct DFToperations, centred at different frequencies.

The DFT is a discrete estimation of a single spectral component of an input signal, equivalent to one single element of a Fourier transform.

More precisely, if $\{x_i\}$ is a discrete sequence of complex values, corresponding to $N$ samples of a complex signal, the channel-k DFT of $\{x_i\}$ is defined by

$$DFT(x, k) = \sum_{i=0}^{N-1} x_i \cdot \left( \sin\left( \frac{2\pi \cdot k \cdot i}{N} \right) + j \cdot \cos\left( \frac{2\pi \cdot k \cdot i}{N} \right) \right), \quad -N \le k < N \qquad 5)$$

or, in compact form

$$DFT(x, k) = \sum_{i=0}^{N-1} x_i W_N^{k,i} \qquad\qquad 6)$$

where

$$W_N^{k,i} = e^{-j\frac{2\pi \cdot k \cdot i}{N}} \qquad\qquad 7)$$

The DFT can therefore be regarded asa linear combination of the samples $x_j$ in which the weights $W$, also indicated as" Twiddle factors", are the $N$ distinct rootsof order $N$ of unity in the complex field, taken in incrementsof k. For a "two sided" spectrum k one may assume both negative and positive integer values ($-N < k < N$).

According to the known frequency shift theorem, the expression 6) above can be also interpreted as an average of a sequence of frequency shifted sinusoids. In fact the term 7) isa complex sinusoid with frequency $\dfrac{k}{NT}$. The product $x_i W_N^{k,i}$ just shifts the spectrum of $x_j$ backwards on the frequency axis by an amount of $\dfrac{k}{NT}$, letting the spectral shape of $x_j$ in itself unchanged. The average operation in the frequency domain hasthe following transfer function:

$$Avg_{TF}(f,N) = N\frac{\sin(2 \cdot \pi \cdot f)}{2 \cdot \pi \cdot f} = N \cdot \mathrm{sinc}(2 \cdot \pi \cdot f) \qquad\qquad 8)$$

where $f$ is the frequency and $N$ is the number of samples.

The transfer function of the DFT operator can therefore be obtained by multiplying the spectrum of the "frequency shifted" signal with the average transfer function 8):

$$|DFT(f)| = N \cdot \left| \frac{\sin\left(2 \cdot \pi \cdot \left(f \cdot T - \dfrac{k}{N}\right)\right)}{2 \cdot \pi \cdot \left(f \cdot T - \dfrac{k}{N}\right)} \right| = \qquad \text{with} \ -N < k < N \qquad 9)$$

$$= N \cdot \left| \mathrm{sinc}\left(f \cdot T - \frac{k}{N}\right) \right|$$

where Trepresentsthe sampling period, $f$ is the frequency of the sinusoidal signal, N isthe number of samples used in the DFT and k isthe discrete position of the DFT central frequency, expressed as number of $1/(N.T)$ units as discussed above.

Referring now to figure 2, it is possible to appreciate the frequency response of three distinct DFT operators 50a, 50b and 50c, centred on three consecutive frequency bins corresponding to $n=-1, n=0,$ and $n=1$, respectively.

The response of each DFT hasthusa central peak 502 at $f = k/NT$, and secondary maxima 504. The response of the DFT operator is strictly zero for any frequency multiple of the DFT bin width $1/NT$, apart the central peak frequency.

The extraction of the absolute value is used to extract the real non-negative amplitude value of the complex DFT output.

A possible manner of building a DFTfrequency estimator involves the evaluation of the quantity

$$f_x = \frac{DFT_D(x) - DFT_U(x)}{DFT_D(x) + DFT_U(x)} \qquad\qquad 10)$$

where $DFT_D$ and $DFT_U$ stand for the operators $|DFT(x,-1)|$ and $|DFT(x,+1)|$ that isto say, the DFT corresponding to curves50aand 50cof figure 2, or, explicitly

$$DFT_U(x) = \sum_{i=0}^{N-1} x_i \cdot e^{-j\frac{2\pi \cdot i}{N}}$$

$$DFT_D(x) = \sum_{i=0}^{N-1} x_i \cdot e^{j\frac{2\pi \cdot i}{N}}$$

or                                                                11)

$$DFT_U(x) = \sum_{i=0}^{N-1} x_i \cdot W_N^i$$

$$DFT_D(x) = \sum_{i=0}^{N-1} x_i \cdot W_N^{-i}$$

In the discriminator of equation 10), the frequency isestimated by meansof the amplitude difference between the two DFT having k=+1 and k=-1. The difference isthen normalized using the sum of the two DFT amplitudes.

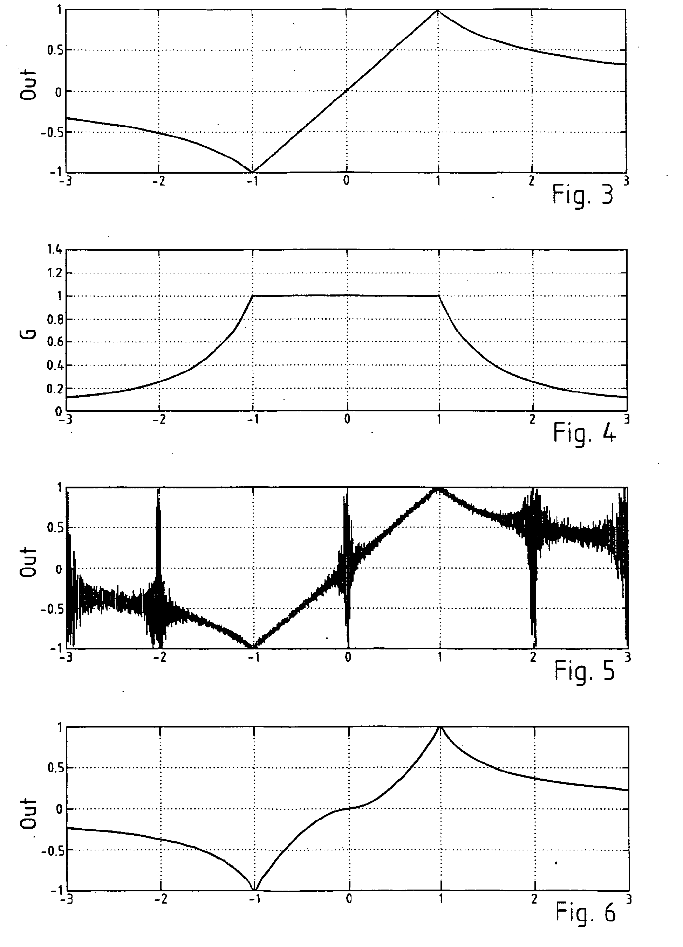

Figures 3 and 4 show the theoretical response of the discriminator of equation 10), and the relative gain. An advantage of this discriminator isthat the response is strictly linear, i.e the gain isconstant, in the frequency range from *f= -1/(NT)* to *f= 1/(NT)*.

A strong limitation of thisapproach is however that, in the frequency region close to f = 0, both DFT are tending to zero, making the difference noise dominated. This problem is amplified by the fact that the normalization factor also tendsto zero, due to the shape of the response $R_x$. The result is therefore mathematically undetermined in the vicinity of f = 0. Figure 5 showsthe same response asfigure 3, but with the addition of simulated random noise in the input signal. It is apparent that this discriminator providesessentially random result for frequencies close to f=0.

The discriminator of equation 10) has therefore a point of instability in the middle of itsfrequency range and is therefore use less in most practical applications. A way to obviate to this problem isto add the DFT 50c corresponding to *k=0* in the normalization factor thus:

$$DFT_{centre}(x) = \sum_{i=0}^{N-1} x_i \cdot e^{-j\frac{2\pi \cdot i \cdot 0}{N}}$$                        12)

$$f_x = \frac{DFT_D(x) - DFT_U(x)}{DFT_D(x) + DFT_{centre}(x) + DFT_U(x)}$$                        13)

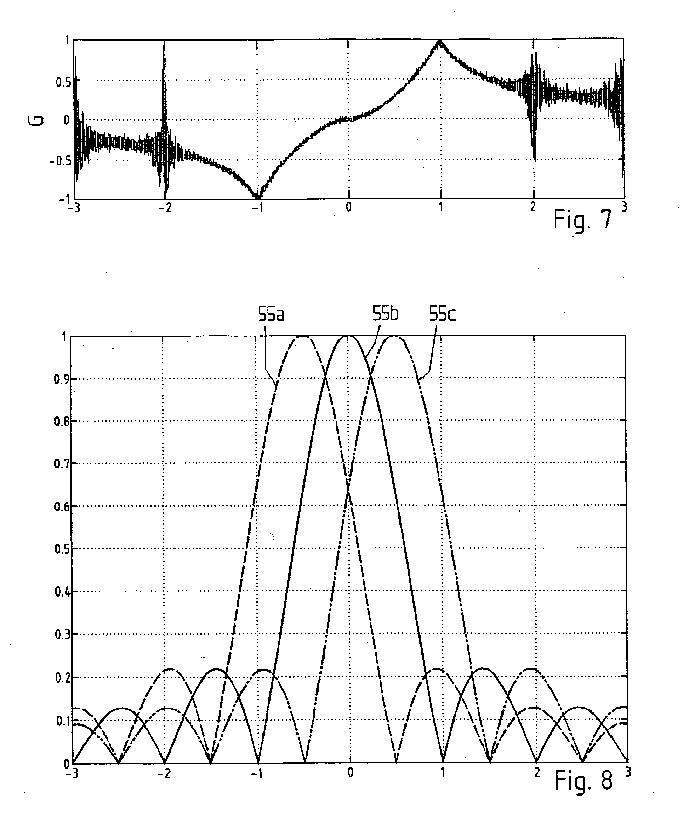

The response of discriminator of equation 13) isshown in figure 6 and, with the addition of simulated noise, in figure 7. Noise immunity is now satisfactory, however the discriminator hasessentially no gain for frequencies very close to f=0. In some application thisfact can be penalizing, in particular it will induce a hysteresis in the FFL loop of figure 1.

According to the present invention, the frequency discriminator comprises the evaluation of two Half-bin Discrete Fourier Transform (HDFT) at different frequencies, wherein the half-bin DFT are defined by formula (3) above, in which the index k takesa half/integer value.

In particular:

$$HDFT(x,-1/2) = \sum_{i=0}^{N-1} x_i \cdot W_N^{-i/2}$$

$$HDFT(x,1/2) = \sum_{i=0}^{N-1} x_i \cdot W_N^{i/2}$$                        14)

However, examination of the expression defining the twiddle factors *W* reveals that

$$W_N^{\frac{k}{2} \cdot i} = W_{2 \cdot N}^{k \cdot i} \qquad\qquad 15)$$

The HDFT is thus calculated in the same manner as the ordinary DFT, but the twiddle factors W are taken as if the order of the Fourier transform was 2N, instead of N.

The transfer function of the HDFT (in absolute value) is still given by equation 9). It can be observed that the transfer function of HDFT operators have a maximum at a half/integer frequency value, with reference to the sampling frequency of the sample set $(x_i)$, whereas the DFT operators defined before have maxima at integer frequency values.

More precisely we define:

$$HDFT_U(x) = \sum_{i=0}^{N-1} x_i \cdot e^{-j\frac{2\pi \cdot i}{2N}}$$

$$HDFT_D(x) = \sum_{i=0}^{N-1} x_i \cdot e^{j\frac{2\pi \cdot i}{2N}}$$

or 16)

$$HDFT_U(x) = \sum_{i=0}^{N-1} x_i \cdot W_{2N}^{i}$$

$$HDFT_D(x) = \sum_{i=0}^{N-1} x_i \cdot W_{2N}^{-i}$$

The formulation of the frequency discriminator becomes then:

$$f(x) \cong \frac{|HDFT_D(x)| - |HDFT_U(x)|}{|HDFT_D(x)| + |HDFT_U(x)|} \qquad\qquad 17)$$

However, the peak frequencies are centred on half-integer values of the DFT bin width $1/NT$.

The frequency extraction operators $H_D$ and $H_U$ involve the linear combination of the samples $x_j$ with weights, or twiddle factors, which are N complex roots of unity from the 2N distinct roots of unity of order 2N.

Figures 8 shows for example the response $HDFT$ 55a corresponding to k=-1/2 and 55c, corresponding to k=1/2. Curve 55b, corresponding to k=0 is identical to curve 50b of figure 2.

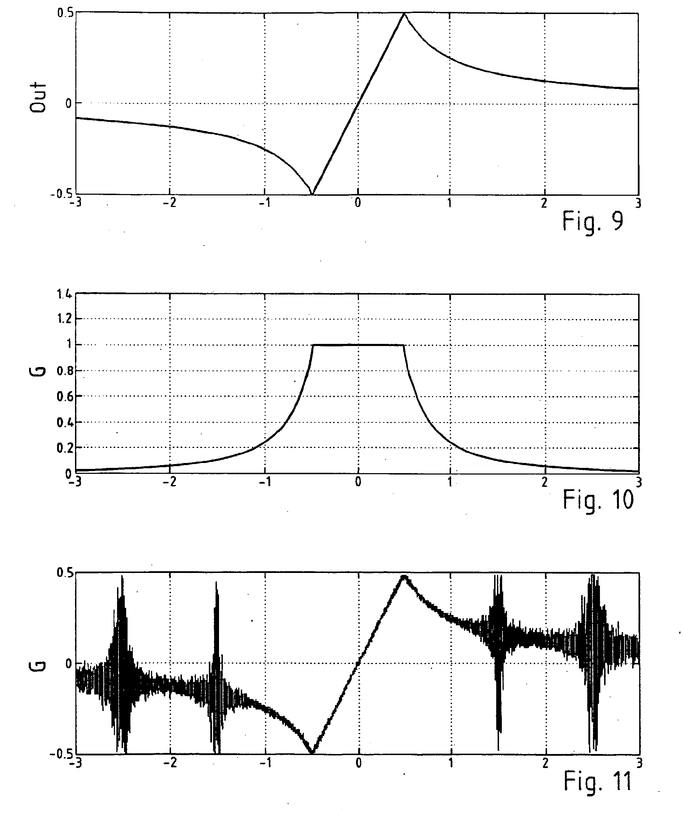

It will be appreciated that, in contrast with $DFT$ curves of figure 2, the curves 55a and 55c do not go to zero simultaneously for f= 0. This allows the construction of a half-bin frequency discriminator with the response and the gain shown in figures 9 and 10.

Advantageously, the half-bin discriminator of the invention exhibits a linear response along all the operating range going from $f_D=-1/2NT$ to $f_U=1/2NT$ and is stable in the entirety of his operating range, since the denominator of equation 17) is not tending to zero for f=0. Figure 11 shows the behaviour of the half-bin discriminator of the invention, in presence of normal distributed noise.

The mathematical formulation of the " Half Bin DFT" can also be deduced from a particular characteristic of the FFT algorithm. A complex FFT takes a vector of N samples of a signal and calculates N spectral lines at $j/NT$ for $0 \leq i < N$. Sometimes, in order to artificially enhance the resolution of the calculated spectra, an FFT of 2N points is calculated adding N zeros at the end of the input sample vector. This operation, generates N new spectral lines placed at $(2i+1)/2NT$ for $0 \leq i < N$ placed exactly in the middle of two N FFT frequency bins. Considering that the FFT algorithm is nothing more than an optimization and a reorganization of a bank of N DFTs we can deduce the formulation of the half bin DFT by replacing the spectral lines 1 and 2N-1 (negative frequency) of a 2N points FFT with his equivalent DFT. The 2N point DFT for k=1 and k=2N-1 becomes:

$$DFT(x, k = 1; 2N-1) = \sum_{i=0}^{2N-1} x_i \cdot e^{-j\frac{2\pi \cdot k \cdot i}{2N}} \quad \frac{N}{2} < k < \frac{N}{2}$$
$$DFT(x, k = 1; 2N-1) = \sum_{i=0}^{2N-1} x_i \cdot W_{2N}^{k \cdot i}$$
$$\text{18)}$$

but considering that the last N pointsof the input vector are zeros:

$$DFT(x, k = 1; 2N-1) = \sum_{i=0}^{N-1} x_i \cdot e^{-j\frac{2\pi \cdot k \cdot i}{2N}} \quad -\frac{N}{2} < k < \frac{N}{2}$$
$$DFT(x, k = 1; 2N-1) = \sum_{i=0}^{N-1} x_i \cdot W_{2N}^{k \cdot i}$$
$$\text{19)}$$

This last formulation is exactly the same asthe formulation of the half bin DFT previously deduced.

According to one aspect of the invention, the frequency discriminator thuscomprisesthe stepsof calculating at least two discrete spectral componentsof an incoming signal, preferably two spectral componentscorresponding to two frequencies $f_D$ and $f_U$, symmetrically placed above and under the zero frequency.

*Each spectral component is extracted by an operator $H_D$ or $H_U$, which hasa maximum of its response for the desired spectral component $f_D$ and $f_U$. The response naturally decreases for different frequencies, but in a manner that the response does not go to zero for any intermediate frequency between $f_D$ and $f_U$. In particular the response of $H_D$ and $H_U$ does not go to zero at the intermediate point f=0.*

Thanksto thisfeature, the discriminator of the invention can extract a frequency error signal, obtained by a step of calculating the difference of the absolute-value outputsof $HDFT_D$ and $HDFT_U$, divided by the sum of the absolute-value outputsof $HDFT_D$ and $HDFT_U$.

Since neither the sum nor the difference of the absolute-value outputsof $HDFT_D$ and $HDFT_U$ is allowed to go to zero in any point of the range between $f_D$ and $f_U$, the discriminator so obtained is well-behaved, even considering the inevitable influence of noise, ant itsvalue is linear between $f_D$ and $f_U$.

By using the HDFT operator described above, the frequencies $f_D$ and $f_U$ of $HDFT_D$ and $HDFT_U$ are $f_D$=-1/2NT to $f_U$=1/2NT, that is they are centred on half-integer values with respect to the natural binning of the sequence of the $N$ in coming digital data $\{x_i\}$, which are sampled at a T sampling rate.

In a preferred embodiment, the operators $HDFT_D$ and $HDFT_U$ have the form set out in equation 17) above. However, the operators $HDFT_D$ and $HDFT_U$ may also be obtained, according to the present invention, from different mathematical operators, for extracting a frequency component of the incoming signal, asthe circumstances may require.

Despite itsdistinct advantages, the half bin discriminator described above still hasthe limitation of having instability pointsoutside the frequency range, at frequency $\pm$ 1.5, $\pm$2.5 and so on. It is possible, in particular if noise is high, that a FLL using such discriminator may lock on these spuriousfrequencies.

A way to avoid this problem isto create a frequency discriminator based on an upper operator and a lower operator, which have a peak of their transfer function for a frequency respectively above and under the reference frequency (here conventionally taken asthe zero frequency), and exhibitsno zerosor discontinuitiesin the operating frequency range.

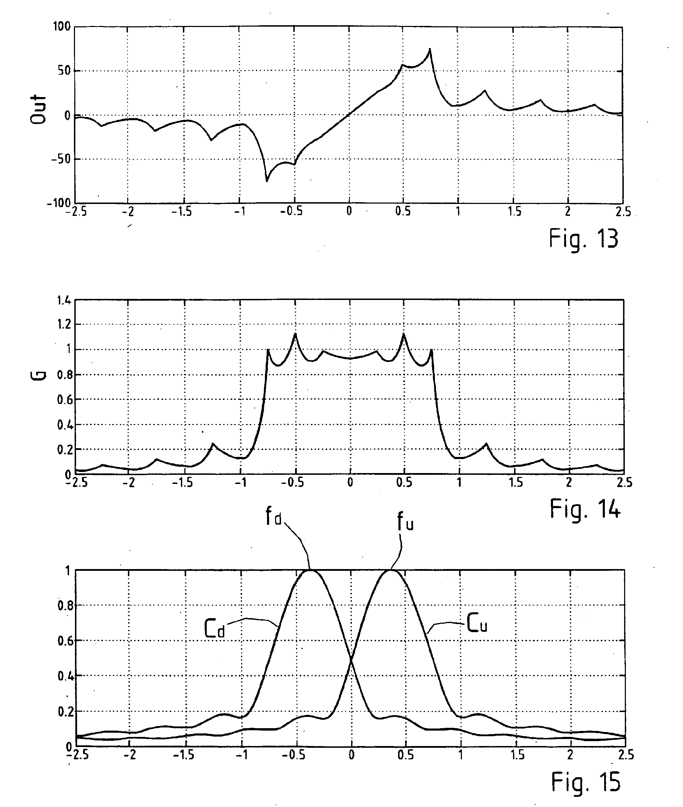

A possible, but not unique, way of defining such upper and lower operator using both the $DFT_U$, $DFT_D$, defined by equations 11), and the $HDTF_U$, $HDFT_D$ defined in 16), is illustrated by operators $C_d$ and $C_U$ having the transfer function illustrated in Figure 15 and the form:

$$C_D = \left| HDFT_D(x) \right| + \left| DFT_D(x) \right|$$
$$C_U = \left| HDFT_U(x) \right| + \left| DFT_U(x) \right|$$
$$\text{20)}$$

Asdesired, the lower compound operator $C_d$ hasa maximum of itstransfer function at a frequency $f_d$ below the reference frequency, marked as 0 in the graph of figure 15. The upper compound operator $C_u$, conversely has its maximum at a frequency $f_u$ above the reference frequency.

It can be seen that $C_D$ and $C_U$ have neither zeros nor discontinuities points in their whole range. It appears therefore that $C_D$ and $C_U$ may be used to create a frequency discriminator which iswell-behaved both inside and outside the locking range.

Since $C_D < C_U$ for $x < 0$ while $C_D > C_U$ for $x > 0$, a simple example of discriminator according to the invention isprovided by the following discriminator function:

$$\frac{C_U - C_D}{C_U + C_D} \qquad \qquad 21)$$

The performances of the above discriminator can be further improved, both in bandwidth and in linearity, by including in the denominator a term proportional $DFT_{centre}$ as defined in equation 12). An improved discriminator according to the invention is, for example, the following Half-bin symmetric DFTdiscriminator:

$$HSDFT(x) = \frac{1}{k_1}\left(\frac{\left|HDFT_U(x)\right| + \left|DFT_U(x)\right| - \left(\left|HDFT_D(x)\right| + \left|DFT_D(x)\right|\right)}{\left|HDFT_D(x)\right| + \left|HDFT_U(x)\right| + k_2 \cdot \left|DFT_{centre}(x)\right|}\right)$$

or, equivalently $\qquad \qquad 22)$

$$HSDFT(x) = \frac{1}{k_1}\left(\frac{C_U - C_D}{\left|HDFT_D(x)\right| + \left|HDFT_U(x)\right| + k_2 \cdot \left|DFT_{centre}(x)\right|}\right)$$

where the coefficients $k_1$ is a normalization factor, which can be chosen essentially at will, and $k_2$ is chosen to have an optimum compromised between bandwidth and linearity of the response. Good performance and a central gain equal to that of the other discriminators are obtained by $k_1 = \sqrt{1.75}$ and $k_2 = 3/2$, for example.

Figures 13 and 14 represent respectively the transfer function and the gain of the discriminator $HSDFT(x)$ of equation 22) . It can be appreciated that the gain is reasonably constant within the extended range of frequencies between -0.75 and 0.75. The locking range of the discriminator based on $HSDFT_{(x)}$ isthen sensibly larger that the one of the other discriminators previously described.

Another advantageousfeature isthat there are neither zeros nor discontinuity or instability point in the whole frequency spectrum, even well beyond the locking range. Thisiseven more apparent by examining the figure 16, in which the transfer function 109d of the discriminator $HSDFI_{(x)}$ according to the invention iscompared with the transfer functions 190b of the "cross" discriminator, 190a of the "crossSign" discriminator and 190c of the "atan" discriminator. The comparison shows also the larger bandwidth of the transfer function 190d with respect to the known ones.

Thanksto these featuresof the invention it is possible to provide a frequency control device which convergesto the target frequency faster and more precisely that devices base on known discriminators In addition, it is possible to provide a frequency control device which has no spurious lock states.

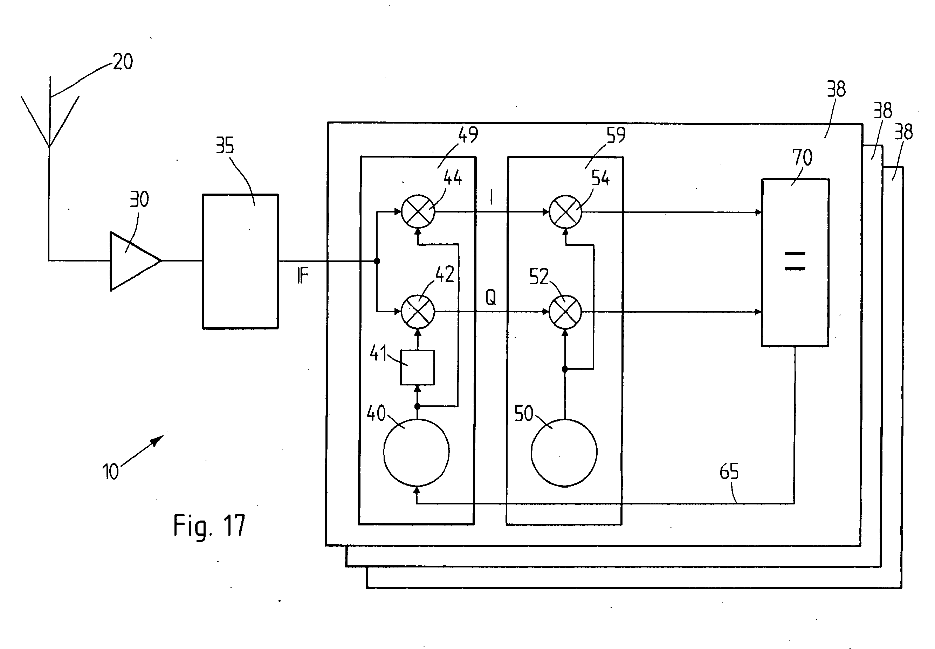

The present invention also comprisesa receiver for a radio positioning system, in particular a GPS receiver, described now with reference to figure 17.

The receiver comprisesa receiving antenna 20, adapted to the specific radio signal of the sources in the radio localization system. In a GPS system the sources are the orbiting GPS Space Vehicles, emitting a radiolocalization signal at 1575.42 MHz. The signal received by the antenna is amplified by the low-noise amplifier 30 and down-converted to an intermediate frequency signal (IF signal) in the conversion unit 35, before being fed to the carrier removal stage 49. Other methodsof processing the RF signal, including for example Analogue-to-Digital Conversion, are conventionally known and comprised in the present invention.

The IF signal isthen fed, among others, to a correlation processor, whose function isto de-spread the signals received from each SV, and to align them temporally with locally generated copies of the pseudorandom ranging codes specific for each SV, for example, in case of a GPS receiver, the correlation processor hasthe task of demodulating and tracking the coarse acquisition (C/A) GPSranging signals. To perform such alignment, the correlators processor comprises an array of tracking modules 38, each of which isdedicated, for example to the acquisition and the tracking of a specific SV.

The variousfunctionsof the tracking modules38 are described in the following with reference to the figure 17.

It isto be understood, however, that thisdescription isgiven by way of example only, and should not be interpreted asa limitation of the present invention. In particular the various elements and modules described must be understood in functional terms, and do not necessarily correspond to physical circuit elements. In particular several functions may be carried out by software modules, executed by one or more digital processors.

Also, even if the varioustracking modules38 are here described as totally independent and parallel, for the sake of clarity, it must be understood, however, that some featuresor resources can be shared among tracking modules, asthe circumstances require.

Each tracking module hasa carrier removal stage 49 comprising, conventionally, a local NCO 40, for generating a local oscillator signal, and a 90˚ phase shifter 41, producing a quadrature replica of the local oscillator signal. In a possible variant, the 90˚ phase shift may be done in a external front-end circuit. The incoming radio signal is multiplied with the in-phase and with the quadrature local oscillator signal in the multipliers44, respectively 42, to produce a baseband in-phase signal I and a baseband quadrature signal Q. In tracking mode, the frequency or phase of the NCO 40 is locked to the carrier frequency or phase of the tracked SV.

Each tracking module 38 comprises also a local Gold pseudorandom code generator 50, for generating a local replica of the C/A code corresponding to a particular GPS Space Vehicle. The Gold pseudorandom codes can be generated internally, for example by a tapped shift register, or, equivalently, extracted from a preloaded table or by any other technique.

The Gold code generator 50 comprisesan independent numerically controlled C/A clock whose frequency isset to produce a C/A code at a chipping rate of 1.023 MHz. The two in-phase (I) and quadrature (Q) componentsof the IF signal are multiplied by multipliers 52, 54 with the local C/A code. During tracking the local C/A code need to be time-locked to the C/A code received from the SV. The local carrier frequency and phase need to be locked to the frequency and phase of the carrier of the received signal, to compensate for Doppler shift on the SV signal and local oscillator frequency drift and bias.

The correlation data for the in-phase signal and for the quadrature signal can be regarded asthe real and imaginary part of a complex signal. In an ideal frequency lock condition, the frequency of the NCO 40 and the frequency of the carrier are identical, and the signal present at the input of the discriminator 70 isa pure baseband signal, whose fundamental frequency iszero. During tracking the discriminator module 70 producesa frequency error signal 65 which is used for driving the NCO 40 of the carrier removal stage in a feedback loop, in order to lock to the frequency of the received signal.

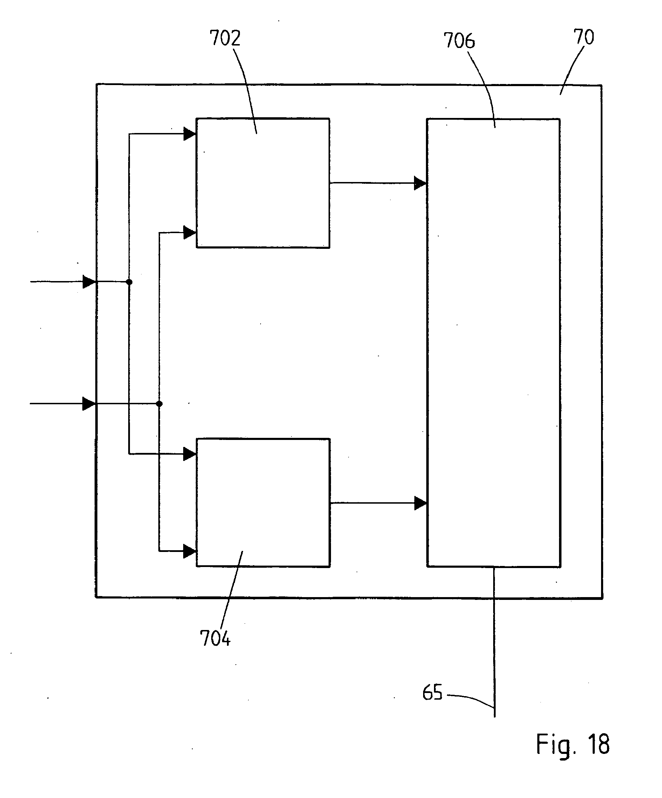

According to the invention, the discriminator module 70, now described with reference to the figure 18, comprisesa frequency discriminator based on the HDFT or preferably on the HSDFTasdescribed above. More particularly, the discriminator module 70 of the invention extract at least two discrete spectral componentsof the incoming signal, preferably two spectral components corresponding to two frequencies $f_D$ and $f_U$, symmetrically placed above and under the zero frequency.

Each spectral component is extracted by frequency extraction means 702 or 704, which have a maximum response for the desired spectral component $f_D$ , respectively $f_U$. The response naturally decreases for different frequencies, but in a manner that the response does not go to zero for any intermediate frequency between $f_D$ and $f_U$. In particular the response of the frequency extraction means702 and 704 do not go to zero at the intermediate point $f=0$. In this manner one ensure the stable behaviour of the discriminator module 70 within its locking range.

Even more preferably, the frequency extraction means702 and 704 have a frequency response that never goesto zero at any frequency. In thisway the control loop including the discriminator module 70 and the NCO 40 has no spurious locking point, apart the designed one.

Thanksto thisfeature, the discriminator of the invention can extract a frequency error signal, obtained by the comparison means706 which are arranged for calculating the difference of the absolute-value outputsof 702 and 704, and preferably for normalizing the difference by dividing it by the sum of the absolute-value outputsof frequency extraction means702 and 704. In a further embodiment, the frequency extraction meanswill often consist of a software module, which contains code for calculating the values $H_D$ and $H_U$, when executed by a microprocessor. In an implementation variant, corresponding to the discriminator of equation 22) above, a supplementary extraction means, not represented, is used to extract the $HDFT_{centre}$ term.

Even if, for the sake of simplicity, this example showsthe frequency extraction means 702 and 704 asseparate entities, it isto be understood that the present invention may also comprise a single frequency extraction means, which extracts the two required spectral components $f_D$, $f_U$ in turn.

By using the HDFTand the HSDFT operators described above, the frequencies $f_D$ and fu are $f_D=-1/2NT$ to $f_U=1/2NT$, that is they are centred on half-integer values with respect to the natural binning of the sequence of the $N$ incoming digital data $\{x_j\}$, which are sampled at a $T$ sampling rate.

In a preferred embodiment, the frequency extraction means702 and 704 implement the operators $H_D$ and $H_U$ that have the form set out in equation 17) above. However, the operators $H_D$ and $H_U$ may also be obtained, according to the present invention, from different mathematical operators, for extracting a frequency component of the incoming signal, as the circumstances may require.

The frequency discriminator of the invention is based on a variant of the DFT transform in which the usual twiddle factors are replaced with twiddle factors as for a DFTon a number of pointswhich is the double asthe actual number of sample points. The DFT so modified allows half-bin frequency discrimination, with few added computational burden. Two DFT shifted of half bin with respect to the zero frequency provide a linear response of the discrimination and good immunity to noise. The frequency estimation and dynamic can be further improved by using both half-bin terms and full-bin termsin the discriminator function, the HSDFT being an example of thistechnique. The discriminator of the invention is particularly useful in FLL for tracking signals in a GPS receiver.

According to the circumstances, the discriminator module 70 may be realized asa dedicated electronic digital circuit, or asa microcontroller device, programmed in a manner asto carry out the stepsof the method of the invention. The invention also comprisesa software code, which can be loaded in the program memory of a computer device, for executing the stepsof set forth above when the program is executed.

## Claims

1. Method of obtaining a frequency difference between a fundamental frequency of an input signal (x) comprising a number of N successive samples ($x_i$) and a reference frequency, comprising the steps of:

   - applying to the samples ($x_i$) a discrete number of spectral component extraction operators (155a, 155b, 155c, 155d, 155e) for extracting the corresponding spectral components of the input signal, in an operating frequency range
   combining mathematically the spectral components to a lower operator ($C_D$,) having a maximum of its transfer function at a lower frequency ($f_d$) under the reference frequency, and a upper operator ($C_U$,) having a maximum of its transfer function at a upper frequency ($f_u$) higher than the lower frequency ($f_d$) and above the reference frequency,
   obtaining the frequency difference from the value of the lower operator and upper operator ($C_U$,), **characterized in that** said lower and upper operators ($C_D$, $C_U$) comprise one or more DFT operators and Half-Bin DFT operators, and **in that** the response of lower operator and upper operator ($C_D$, $C_U$) exhibits no zeros or discontinuities in the operating frequency range.

2. Method according to the preceding claim, wherein the response of the lower and upper operators ($C_D$, $C_U$) exhibits no zeros or discontinuities at any frequency.

3. Method according to the any of the preceding claims, **characterized in that** the upper frequency ($f_D$) and the lower frequency ($f_U$) are symmetrically placed around the reference frequency.

4. Method according to any of the preceding claims, **characterized in that** the reference frequency is the zero frequency.

5. Method according to any of the preceding claims, **characterized in that** the two lower and upper operators ($C_D$, $C_U$) comprise a step of calculating an absolute value of the output.

6. Method according to any of the preceding claims, **characterized in that** each of the lower and upper operators ($C_D$, $C_U$) is a combination of a DFT operation, obtained by a linear combination of the samples ($x_i$), with weight (W) factors taken from the N distinct complex roots of unity of order N, and of a Half-bin DFT operation, obtained by a linear combination of the samples ($x_i$), with weight (W) factors taken from the 2N distinct complex roots of unity of order 2N.

7. Method according to the preceding claim, wherein at least one of the DFT operators corresponds to the reference frequency.

8. Device, comprising an input, for receiving an input signal comprising a number of N successive samples ($x_i$), and a discriminator module (70), for generating, in an operating frequency range, an output signal (65) dependent on a frequency difference from a fundamental frequency of the input signal and a reference frequency; wherein the discriminator module (70) comprises a lower frequency extraction means (702) for extracting a discrete spectral component of the input signal, at a lower frequency ($f_D$) and an upper frequency extraction means (704) for extracting a discrete spectral component of the input signal at a upper frequency ($f_U$), the upper frequency ($f_U$) and the lower frequency ($f_D$) being placed above and under the reference frequency, whereas the upper and lower frequency extraction means (702, 704) have a maximum of its response for the corresponding spectral component; comparison means (706) arranged for calculating the difference of the absolute-value outputs of the frequency extraction means (702 and 704), providing a frequency error signal;

**characterized in that**:

the frequency extraction means (702, 704) are operatively arranged to compute one or more DFT operators and Half-Bin DFT (HDFT) operators and to compute said discrete spectral components of the signal at said lower frequency ($f_D$) and said upper frequency ($f_U$) based on said one or more DFT operators and Half-Bin DFT (HDFT) operators, and **in that** the response of the frequency extraction means (702, 704) does not exhibit zeros or discontinuities for any frequency in the operating frequency range.

9. Device according to claim 8, wherein the reference frequency is a zero frequency.

10. Device according to claim 8, further comprising a variable frequency source (14) and a mixer (45) for combining said input frequency (12) with an output of the variable frequency source (14), the device comparing an output signal of the mixer and generating a frequency error signal (65), for driving the variable frequency source (14) and locking it to the input frequency (12), so to constitute a frequency control device.

11. Device according to one of the claims 8 to 10, included in a GPS receiver.

12. Digital data carrier, comprising software code to carry out the steps of methods of one of claims 1 to 7.

13. Computer program adapted to carry out the steps of methods of one of claims 1 to 7.

14. Use of the method of one of claims 1 to 7 in a GPS receiver.

**Patentansprüche**

1. Verfahren, um eine Frequenzdifferenz zwischen einer Grundfrequenz von einem Eingangssignal (x) umfassend eine Anzahl von N nacheinander folgenden Abtastpunkten ($x_i$) und einer Referenzfrequenz zu erhalten, umfassend die Schritte von

- Anwendung an die Abtastpunkte ($x_i$) eine diskrete Anzahl von Spektralkomponentenextraktionsoperatoren (155a, 155b, 155c, 155d, 155e), um die korrespondierende Spektralkomponenten des Eingangssignals in einem Betriebsfrequenzbereich zu extrahieren,
- mathematisches Kombinieren der Spektralkomponenten zu einem kleineren Operator ($C_D$), der ein Maximum seiner Transferfunktion an einer unteren Frequenz ($f_D$) unter der Referenzfrequenz hat, und einen oberen Operator ($C_U$), der ein Maximum seiner Transferfunktion an einer oberen Frequenz ($f_U$) höher als die untere Frequenz ($f_D$) und über der Referenzfrequenz hat,
- Erhalten der Frequenzdifferenz von einem Wert des unteren Operators und des oberen Operators ($C_U$), **gekennzeichnet, dadurch dass** besagte untere und obere Operatoren ($C_D$, $C_U$) einen oder mehrere DFT Operatoren und Half-Bin DFT Operatoren umfassen und **dadurch** dass die Antwort des unteren Operators und des oberen Operators ($C_D$, $C_U$) keine Nullstellen oder Diskontinuitäten in dem Betriebsfrequenzbereich aufweist.

2. Verfahren gemäss dem vorhergehenden Anspruch, in welchem die Antwort des unteren und oberen Operators ($C_D$, $C_U$) keine Nullstellen oder Diskontinuitäten bei irgendeiner Frequenz aufweist.

3. Verfahren gemäss einem der vorhergehenden Ansprüche, **gekennzeichnet, dadurch dass** die obere Frequenz ($f_D$) und die untere Frequenz ($f_U$) symmetrisch um die Referenzfrequenz platziert sind.

4. Verfahren gemäss einem der vorhergehenden Ansprüche, **gekennzeichnet, dadurch dass** die Referenzfrequenz die Nullfrequenz ist.

5. Verfahren gemäss einem der vorhergehenden Ansprüche, **gekennzeichnet, dadurch** die zwei unteren und oberen Operatoren ($C_D$, $C_U$) einen Schritt von Berechnen eines absoluten Ausgangswerts umfassen.

**6.** Verfahren gemäss einem der vorhergehenden Ansprüche, **gekennzeichnet, dadurch** jeder der der unteren und oberen Operatoren ($C_D$, $C_U$) eine Kombination einer DFT Operation ist, die durch eine lineare Kombination von Abtastpunkten ($x_i$) mit Gewichtsfaktoren (W) erhalten wird, wobei die Gewichtsfaktoren (W) von N distinkten komplexen Einheitswurzeln in der Grössenordnung N genommen wurden, und von einer Half-bin DFT Operation, die durch eine lineare Kombination von Abtastpunkten ($x_i$) mit Gewichtsfaktoren (W) erhalten wird, wobei die Gewichtsfaktoren (W) von 2N distinkten komplexen Wurzeln von der Grössenordnung 2N genommen wurden.

**7.** Verfahren gemäss dem vorhergehenden Anspruch, in welchem mindestens einer der DFT Operatoren zu der Referenzfrequenz korrespondiert.

**8.** Vorrichtung umfassend einen Eingang, um ein Eingangssignal zu empfangen, umfassend eine Anzahl von N nacheinander folgenden Abtastpunkten ($x_i$) und einem Diskriminatormodul (70), um in einem Betriebsbereich ein Ausgangssignal (65) in Abhängigkeit von einer Frequenzdifferenz von einer Grundfrequenz des Eingangssignals und einer Referenzfrequenz zu generieren; wobei das Diskriminatormodul (70) ein Mittel (702) zur Extrahierung einer unteren Frequenz umfasst, um eine diskrete Spektralkomponente des Eingangssignals an einer unteren Frequenz ($f_D$) zu extrahieren, und ein Mittel (704) zur Extrahierung einer oberen Frequenz, um eine diskrete Spektralkomponente des Eingangssignals an einer oberen Frequenz ($f_U$) zu extrahieren, wobei die obere Frequenz ($f_U$) und die untere Frequenz ($f_D$) sind über und unter der Referenzfrequenz platziert sind, während die Mittel (702, 704) zur Extraktion zu oberen und unteren Frequenz ein Maximum von ihrer Antwort für die korrespondierende Spektralkomponente haben; Vergleichsmittel (706), die angeordnet sind, um die Differenz des Absolutwerteausgangs der Mittel (702, 704) zur Extraktion der Frequenzen zu berechnen, was ein Fehlerfrequenzsignal bereitstellt, **gekennzeichnet, dadurch dass**:

die Mittel zur Extraktion der Frequenzen (702, 704) sind operativ angeordnet, um ein oder mehrere DFT Operatoren und Half-bin Operatoren (HDFT) zu berechnen und um besagte diskrete Spektralkomponenten von dem Signal an besagter unterer Frequenz ($f_D$) und an besagter oberer Frequenz ($f_U$) basierend auf besagten einen oder mehreren DFT Operatoren oder Half-bin operatoren DFT (HDFT) zu berechnen, und **dadurch** dass die Antwort der Mittel zur Extraktion der Frequenzen (702, 704) keine Nullstellen oder Diskontinuitäten für irgendeine Frequenz in dem Betriebsfrequenzbereich aufweist.

**9.** Vorrichtung gemäss Anspruch 8, in welchem die Referenzfrequenz eine Nullfrequenz ist.

**10.** Vorrichtung gemäss Anspruch 8, weiter umfassend eine variable Frequenzquelle (14) und einem Mixer (45), um besagte Eingangsfrequenz (12) mit einem Ausgang der variable Frequenzquelle (14) zu kombinieren, die Vorrichtung vergleicht ein Ausgangssignal des Mixers und generiert ein Frequenzfehlersignal (65), um die variable Frequenzquelle (14) anzutreiben und sie an die Eingangfrequenz (12) anzuschliessen, um eine Frequenzkontrollvorrichtung bereitzustellen.

**11.** Vorrichtung gemäss einem der Ansprüche 8 bis 10 enthalten in einem GPS Empfänger.

**12.** Digitaler Datenträger, umfassend einen Softwarecode um die Schritte der Verfahren einer der Ansprüche 1 bis 7 durchzuführen.

**13.** Computerprogrammprodukt angepasst, um die Schritte der Verfahren gemäss einem der Ansprüche 1 bis 7 durchzuführen.

**14.** Verwendung des Verfahrens von einem der Ansprüche 1 bis 2 in einem GPS-Empfänger.

**Revendications**

**1.** Méthode pour obtenir une différence de fréquence entre une fréquence fondamentale d'un signal d'entrée (x) comportant un nombre N de points de mesure successifs ($x_i$) et une fréquence de référence, comprenant les étapes suivantes :

- appliquer aux points de mesure ($x_i$) un nombre discret d'opérateurs d'extraction de composant spectral (155a, 155b, 155c, 155d, 155e), pour extraire les composants spectraux correspondant au signal d'entrée, dans une fourchette de fréquence de fonctionnement,

- combiner mathématiquement les composants spectraux à un opérateur inférieur ($C_D$) ayant un maximum de sa fonction de transfert à une fréquence inférieure ($f_D$) sous la fréquence de référence, et à un opérateur supérieur ($C_U$) ayant un maximum de sa fonction de transfert à une fréquence supérieure ($f_U$) au-dessus de la fréquence inférieure ($f_D$) et au-dessus de la fréquence de référence,

- obtenir la différence de fréquence entre les valeurs de l'opérateur inférieur et de l'opérateur supérieur ($C_U$), **caractérisé en ce que** lesdits opérateurs inférieur et supérieur ($C_D$, $C_U$) comprenant un ou plusieurs opérateurs DFT et des opérateurs DFT Half-Bin et **en ce que** la réponse de l'opérateur inférieur et de l'opérateur supérieur ($C_D$, $C_U$) ne fasse apparaître aucune valeur nulle ou discontinuité dans la fourchette de fréquence de fonctionnement.

2. Méthode selon la revendication précédente, selon laquelle la réponse de l'opérateur inférieur et de l'opérateur supérieur ($C_D$, $C_U$) ne fasse apparaître aucune valeur nulle ou discontinuité à aucune fréquence.

3. Méthode selon l'une des revendications précédentes, **caractérisée en ce que** la fréquence supérieure ($f_D$) et la fréquence inférieure ($f_U$) sont placées symétriquement autour de la fréquence de référence.

4. Méthode selon l'une des revendications précédentes, **caractérisée en ce que** la fréquence de référence est la fréquence nulle.

5. Méthode selon l'une des revendications précédentes, **caractérisée en ce que** les deux opérateurs inférieur et supérieur ($C_D$, $C_U$) comportent une étape de calcul d'une valeur absolue de la sortie.

6. Méthode selon l'une des revendications précédentes, **caractérisée en ce que** chacun des opérateurs inférieur et supérieur ($C_D$, $C_U$) est une combinaison d'une opération DFT, obtenue par la combinaison linéaire des points de mesure ($x_i$) avec les facteurs de poids (W) obtenus des N racines d'unité distinctes et complexes de valeur N, et d'une opération DFT Half-Bin, obtenue par la combinaison linéaire des points de mesure ($x_i$) avec les facteurs de poids (W) obtenus des 2N racines d'unité distinctes et complexes de valeur 2N.

7. Méthode selon la revendication précédente, selon laquelle au moins un des opérateurs DFT correspond à la fréquence de référence.

8. Dispositif comprenant une entrée pour recevoir un signal d'entrée, comprenant un nombre N de points de mesure successifs ($x_i$) et un module discriminateur (70), pour générer, dans une fourchette de fréquence de fonctionnement, un signal de sortie (65) dépendant d'une différence de fréquence entre la fréquence fondamentale du signal d'entrée et d'une fréquence de référence ; selon lequel de module discriminateur (70) comporte des moyens d'extraction d'une fréquence inférieure (702), pour extraire un composant spectral discret du signal d'entrée à une fréquence inférieure ($f_D$), et des moyens d'extraction d'une fréquence supérieure (704), pour extraire un composant spectral discret du signal d'entrée à une fréquence supérieure ($f_U$), selon lesquelles la fréquence supérieure ($f_U$) et la fréquence inférieure ($f_D$) sont placées au-dessus et au-dessous de la fréquence de référence, considérant que les moyens d'extraction de fréquence inférieure et supérieure (702, 704) sont au maximum de leur réponse dans le composant spectral correspondant; des moyens de comparaison (706) arrangés pour calculer la différence des valeurs absolues de sortie des moyens d'extraction de fréquence (702, 704), ce qui produit un signal d'erreur de fréquence,

**caractérisé en ce que** :

les moyens d'extraction de fréquence (702, 704) sont disposés à calculer un ou plusieurs opérateurs DFT et opérateurs Half-bin DFT (HDFT) et à calculer lesdits composants spectraux discrets du signal à ladite fréquence inférieure ($f_D$) et à ladite fréquence supérieure ($f_U$) en se basant sur ledit ou lesdits opérateurs DFT ou opérateurs Half-bin DFT (HDFT), et **en ce que** la réponse des moyens d'extraction de fréquence (702, 704) ne présente aucune valeur nulle ou discontinuités pour quelconque fréquence dans la fourchette de fréquence de fonctionnement.

9. Dispositif selon la revendication 8, selon lequel la fréquence de référence est une fréquence de valeur nulle.

10. Dispositif selon la revendication 8, comportant d'autre part une source de fréquence variable (14) et un mixer (45), pour combiner ladite fréquence d'entrée (12) avec une sortie de la source de fréquence variable (14), le dispositif comparant un signal de sortie du mixer et générant un signal d'erreur de fréquence (65), pour entraîner la source de fréquence variable (14) et la verrouiller à la fréquence d'entrée (12), de manière à constituer un dispositif de contrôle de fréquence.

11. Dispositif selon l'une des revendications 8 à 10 incorporé dans un récepteur GPS.

12. Support de données numérique comprenant un code de logiciel pour effectuer les étapes des méthodes d'une des revendications 1 à 7.

13. Programme d'ordinateur adapté pour effectuer les étapes des méthodes d'une des revendications 1 à 7.

14. Usage des méthodes d'une des revendications 1 à 2 dans un récepteur GPS.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

EP 1 837 994 B1

Fig. 17

Fig. 18

**EP 1 837 994 B1**

## REFERENCES CITED IN THE DESCRIPTION

**Patent documents cited in the description**

- US 5290181 A